(19) Europäisches Patentamt
European Patent Office
Office européen des brevets

(11) **EP 2 336 793 A1**

(12) **EUROPEAN PATENT APPLICATION**

(43) Date of publication:
**22.06.2011 Bulletin 2011/25**

(51) Int Cl.:
***G01R 31/00*** *(2006.01)*

(21) Application number: **10195160.6**

(22) Date of filing: **15.12.2010**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(30) Priority: **21.12.2009 JP 2009289206**

(71) Applicant: **Nissin Electric Co., Ltd.
Kyoto 615-8686 (JP)**

(72) Inventor: **Tanaka, Takashi
Kyoto-shi Kyoto 615-8686 (JP)**

(74) Representative: **Grünecker, Kinkeldey,
Stockmair & Schwanhäusser
Anwaltssozietät
Leopoldstrasse 4
80802 München (DE)**

(54) **Impulse current generator**

(57)     An impulse current generator includes first and second output terminals to which the load is connected, a capacitor, an inductance, a resistor, and a discharge gap device connected in series between the first and second output terminals, and a DC charge circuit configured to charge the capacitor. The discharge gap device comprises a fixed electrode, movable electrode, and an electrode drive configured to drive the movable electrode toward the fixed electrode and to bring the movable electrode into contact with the fixed electrode.

*FIG. 3*

**Description**

[Technical Field]

This invention relates to an impulse current generator (ICG) for supplying an impulse current to load, such as a surge protection device (SPD) and any other electric device, for test, etc. Further, the invention relates to an impulse current generator for supplying a current with a commercial frequency current superposed on an impulse current to a surge protection device.

In the Specification, the surge protection device is a device defined in JIS C 5381:2004 instituted in 2004. That is, the surge protection device is a device intended for limiting a transient overcurrent and diverting a surge current. The device contains one or more nonlinear elements. This means that the surge protection device is a generic name for devices conventionally called an arrester, a lightning discharger, a surge absorber, etc.

[Background Arts]

Main circuit systems of the impulse current generator for supplying an impulse current to a load include an RLC circuit and a crowbar circuit system as described in Non-patent Document 1.

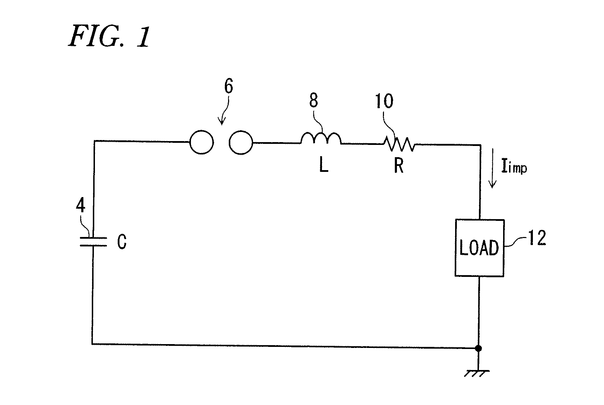

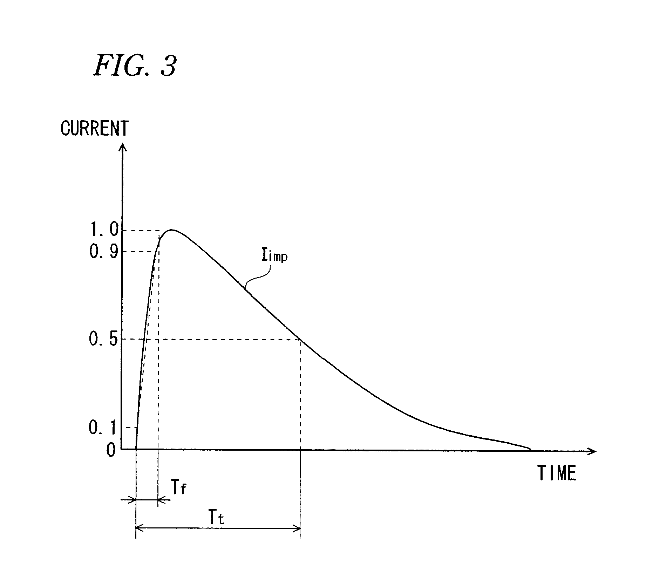

As shown in FIG. 1, in the RLC circuit system, a load 12 is connected to a series circuit of a capacitor 4, a discharge gap 6, an inductance 8, and a resistor 10. A DC high voltage is charged in the capacitor 4 and a trigger is applied to the discharge gap 6 for discharging (namely, conducting), whereby an impulse current $I_{imp}$ can be supplied to the load 12 by the charge stored in the capacitor 4. FIG. 3 shows an example of a waveform of the impulse current $I_{imp}$.

In the circuit system, letting the capacitance of the capacity 4 be C, the inductance of the inductance 8 be L, and the resistance value of the resistor 10 be R, crest length $T_f$ and duration of wave tail $T_t$ of the impulse current $I_{imp}$ are determined by the ratio between the resistance value R of the resistor 10 and the value of surge impedance $\sqrt{(L/C)}$.

Trigger electrodes for the discharge gap 6 and a crowbar gap 14 described later, a trigger circuit, and the like are not shown in the figure.

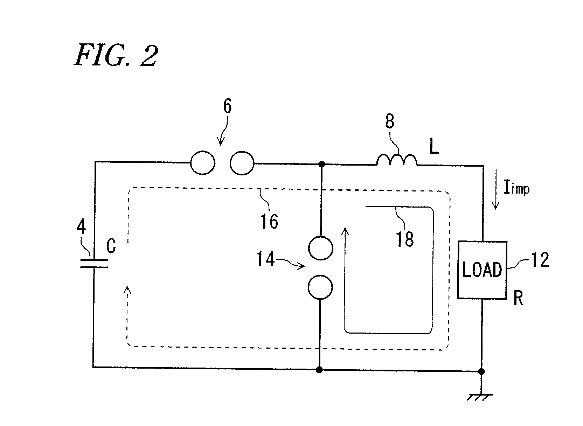

As shown in FIG. 2, in the crowbar circuit system, a load 12 is connected to a series circuit of a capacitor 4, a discharge gap 6, and an inductance 8. A crowbar gap 14 is provided at an intermediate point. A DC high voltage is charged in the capacitor 4 and a trigger is applied to the discharge gap 6 for discharging (namely, conducting), whereby a charge stored in the capacitor 4 flows in an energization route 16, is supplied to the load 12 as an impulse current $I_{imp}$, and is consumed and a part is stored in the inductance 8. In this process, a crest part of the time width (crest length $T_f$) determined by $0.4 \pi \sqrt{(L/C)}$ occurs.

Next, when the impulse current $I_{imp}$ reaches a peak, a trigger is applied to the crowbar gap 14 and it is discharged (namely, brought into conduction), whereby an energization route 18 with the inductance 8 as a power supply is formed. In this process, letting the resistance value of the load 12 be R, a wave tail part with a time constant L/R occurs and duration of wave tail $T_t$ is determined.

[Related Art Documents]

[Patent Documents]

[Non-patent Document 1] TANAKA Kazuhiko and three persons, "Kouatushikensouchi no saishingijyutudouk-ou," Nisshindenki Gihou, Nisshindenki kabushikikaisha, March 11, 2008, 53th volume (No. 130), pages 27-37

[Summary of the Invention]

The crowbar circuit system does not require a resistor component (namely, an energy consumption current) other than the load 12 and thus has the advantage that the energy efficiency is high as compared with the RLC circuit system; whereas, it has the disadvantages that (a) the wave tail part of the impulse current $I_{imp}$ depends on the resistance value R of the load 12 and thus needs to be adjusted each time the load 12 changes, that (b) the crowbar gap 14 and its discharge control circuit (trigger circuit and its control circuit, etc.,) are required in addition to the discharge gap 6 and its discharge control circuit (trigger circuit, etc.,) and the configuration is complicated and is upsized, and the like.

On the other hand, the RLC circuit system has the advantages that (a) crest length $T_f$ and duration of wave tail $T_t$ of the impulse current $I_{imp}$ are determined independently of the load 12 and thus adjustment conforming to the load 12 is not required and general versatility is high and that (b) the crowbar gap and its discharge control circuit as in the crowbar circuit system are not required and the configuration is simple; whereas it has the disadvantages that when the voltage of the capacitor 4 becomes low in the wave tail part of the impulse current $I_{imp}$, it becomes impossible to maintain discharge of the discharge gap 6 and the waveform of the impulse current $I_{imp}$ may become a waveform where the wave tail part of the impulse current $I_{imp}$ is cut.

In the above-mentioned JIS instituted in 2004, for the crest length $T_f$/duration of wave tail $T_t$, a test waveform of a long duration of wave tail of 10/350 $\mu$s is also stipulated in addition to the previous waveform of 8/20 $\mu$s and for the waveform of a long duration of wave tail, a current cut in the wave tail part easily occurs.

In the impulse current generator of the conventional RLC circuit, to prevent current cut in the wave tail part, for example, means for making charge voltage of the capacitor 4 higher (for example, about 200 kV) than the conventional one (for example, about 20 kV) and reliably maintaining discharge of the discharge gap 6 even when the voltage of the capacitor 4 lowers can be adopted. However, if the charge voltage of the capacitor 4 is made high as mentioned above, the charge circuit for the capacitor 4 needs to be a charge circuit for outputting a high voltage and circuit insulating measures become very difficult. Thus, a new problem in that the cost very increases occurs.

The impulse current generator may energize an impulse current in a predetermined waveform and the voltage is scarcely important. Thus, it is not rational to expend much cost for high-voltage insulating measures, etc.

It is an object of the invention to improve an impulse current generator of a conventional RLC circuit system and provide an impulse current generator that can prevent current cut in the wave tail part of an impulse current if the charge voltage of the capacitor is not made high.

By the way, the above-mentioned JIS, more specifically Section 7.6.5 of JIS C 5381-1:2004 stipulates that "voltage of Uc is applied to SPD from a power supply having a nominal current capacity of 5 A or more. This test is conducted by increasing a current impulse to $I_{peak}$ (according to 3.9) or $I_{max}$ (according to 3.10) step by step through the SPD." as an operating duty test of Class I test and Class II test. To conduct the operating duty test, it is necessary to supply a current with a commercial frequency current superposed on an impulse current to a surge protection device (SPD) and conduct test (which will be hereinafter called commercial frequency current superposition test).

As the commercial frequency current superposition test, test conforming to the standard cannot be conducted in Japan even with an impulse current generator adopting the RLC circuit system or crowbar circuit system for the reason that phase adjustment of the impulse current and the commercial frequency current is difficult, etc.

In the crowbar circuit system, a closed circuit is formed in the crowbar gap 14 during energizing of impulse current $I_{imp}$ and it becomes an obstacle of energizing commercial frequency current to the surge protection device of load. Thus, it is difficult to realize the commercial frequency current superposition test in the crowbar circuit system.

It is another object of the invention to further improve an impulse current generator of a conventional RLC circuit system and provide an impulse current generator that can prevent current cut in the wave tail part of an impulse current if the charge voltage of the capacitor is not made high and in addition, can supply a current with a commercial frequency current superposed on an impulse current to a surge protection device.

An impulse current generator for supplying an impulse current to a load, according to a first aspect of the invention, comprises:

first and second output terminals to which the load is connected;
a capacitor, an inductance, a resistor, and a discharge gap device connected in series between the first and second output terminals; and
a DC charge circuit configured to charge the capacitor,
wherein the discharge gap device comprises a fixed electrode, a movable electrode, and an electrode drive configured to drive the movable electrode toward the fixed electrode and to bring the movable electrode into contact with the fixed electrode.

An impulse current generator for supplying a current with a commercial frequency current superposed on an impulse current to a surge protection device to be tested, the impulse current generator, according to a second aspect of the invention, comprises:

first and second output terminals to which the surge protection device is connected;
a main capacitor, an inductance, a resistor, a main discharge gap device, and an auxiliary discharge gap connected in series between the first and second output terminals, the main discharge gap device comprising a fixed electrode, a movable electrode, an electrode drive configured to drive the movable electrode toward the fixed electrode and to bring the movable electrode into contact with the fixed electrode, and a trigger electrode configured to start discharge between the fixed electrode and the movable electrode;
a DC charge circuit configured to charge the main capacitor;
a commercial frequency power supply circuit connected in series through a reactor between the first and second output terminals and configured to output a current of a commercial frequency;
a trigger generation circuit configured to supply a trigger voltage to the trigger electrode of the main discharge gap device; and
a control circuit configured to perform control for synchronizing drive of the movable electrode by the electrode drive device of the main discharge gap device and output of the trigger voltage from the trigger generation circuit with each other, and to perform control for outputting the trigger voltage when the output voltage of the commercial frequency power supply circuit is a predetermined phase,

wherein discharge start voltage of the auxiliary discharge gap is lower than the discharge voltage of the main capacitor and is higher than output voltage of the commercial frequency power supply circuit.

According to a third aspect of the invention, the control circuit may perform control for outputting the trigger voltage from the trigger generation circuit when the phase of the output voltage of the commercial frequency power supply circuit is almost $\pi/2$ [rad].

According to a fourth aspect of the invention, the impulse current generator may further comprise:

an auxiliary capacitor connected in parallel to the commercial frequency power supply circuit between the commercial frequency power supply circuit and the reactor and configured to form a resonance circuit resonating at the commercial frequency in cooperation with the reactor.

According to the impulse current generator of the first aspect of the invention, the movable electrode of the discharge gap device can be driven toward the fixed electrode and can be brought into contact with the fixed electrode by the electrode drive, so that if the voltage of the capacitor becomes low in the wave tail part of the impulse current, energization in the discharge gap device 30a can be maintained. Therefore, unless the charge voltage of the capacity is made high, a current cut in the wave tail part of the impulse current can be prevented.

Moreover, the movable electrode of the discharge gap device is driven as described above, whereby discharge in the discharge gap device can be started without providing a trigger electrode, so that a trigger electrode and the trigger circuit become unnecessary.

According to the second aspect of the invention, the main discharge gap device includes the movable electrode and the electrode device. Thus, if the voltage of the main capacitor lowers in the wave tail part of the impulse current, conduction in the main discharge gap device can be maintained as with the case of the invention as claimed in claim 1. Moreover, the discharge start voltage of the auxiliary discharge gap is lower than the charge voltage of the main capacitor and thus if the voltage of the main capacitor lowers in the wave tail part of the impulse current lowers, conduction in the auxiliary discharge gap can be maintained for a long term. Therefore, if the charge voltage of the main capacitor is not made high, current cut in the wave tail part of the impulse current can be prevented.

Further, the commercial frequency power supply circuit is included, the impulse current flows into the surge protection device and the surge protection device conducts, whereby the commercial frequency current flows into the surge protection device from the commercial frequency power supply circuit. Therefore, the current with the commercial frequency current superposed on the impulse current can be supplied to the serve protection device. Moreover, the controller performs control for synchronizing, etc., so that the commercial frequency current can be well synchronized with and superposed on the impulse current in predetermined phase relationship.

Moreover, interference of the impulse source side and the commercial frequency power supply circuit can be well prevented by the reactor and the auxiliary discharge gap and auxiliary discharge gap acts, whereby the commercial frequency current can be well supplied to the surge protection device as a continuous flow of the impulse current. That is, the reactor acts like an inhibition filter for the impulse current, so that the impulse current can be prevented from flowing into the commercial frequency power supply circuit. In the superposing described above, discharge of the auxiliary discharge gap naturally disappears and the auxiliary discharge gap is opened with voltage lowering of the main capacitor, so that the commercial frequency power supply circuit and the impulse source side can be separated. Accordingly, the commercial frequency current can be prevented from flowing into the impulse source side and the current supplied to the surge protection device can be well continuously switched from the impulse current to the commercial power supply.

According to the third aspect of the invention, the following further advantage is provided: The control circuit performs control for causing the trigger generation circuit to output trigger voltage when the phase of the output voltage of the commercial frequency power supply circuit is almost $\pi/2$ [rad]. Thus, when the phase of the output voltage of the commercial frequency power supply circuit is almost equal to the delay phase of the series circuit containing the reactor and the surge protection device, the main discharge gap device can be discharged and the surge protection device can be brought into conduction by the impulse current. Accordingly, the commercial frequency current supplied from the commercial frequency power supply circuit to the surge protection device can be raised almost from 0 when the surge protection device conducts and occurrence of a transient phenomenon in the commercial frequency current can be prevented. Consequently, current of a waveform with the commercial frequency current well joined to the impulse current can be supplied to the surge protection device, so that it is made possible to more precisely conduct the commercial frequency current superposition test for the surge protection device.

According to the fourth aspect of the invention, the following further advantage is provided: When the surge protection device conducts, a transient current flows into the surge protection device by the charge stored in the auxiliary capacity and moreover becomes a current shaped like a sine wave oscillating (damped oscillating) at the commercial frequency. Such a current can be supplied to the surge protection device from other than the commercial frequency power supply circuit. Thus, to supply the commercial frequency current of a predetermined size to the surge protection device, the capacity of the commercial frequency power supply circuit can be lessened. Accordingly, miniaturization, cost reduction, etc., of the commercial frequency power supply circuit 48 and in turn, miniaturization, cost reduction, etc., of the impulse current generator can be accomplished.

[Brief Description of the Drawings]

FIG. 1 shows an impulse current generator of an RLC circuit system in a prior art.
FIG. 2 shows an impulse current generator of a crowbar circuit system in the prior art.
FIG. 3 shows one example of a waveform of an impulse current.
FIG. 4 shows one embodiment of an impulse current generator according to the invention.
FIG. 5 shows a second embodiment of an impulse current generator according to the invention.
FIG. 6 is a flowchart showing an example of an operation of the impulse current generator shown in FIG. 5.
FIG. 7 shows an example of a waveform of a current obtained by superposing a commercial frequency current on an impulse current.
FIG. 8 is a view for explaining a current flowing when an AC voltage is applied to a RL series circuit.
FIG. 9 is a view for explaining a transient current flowing when the charge stored in the capacitor is abruptly discharged in a RLC series circuit.

[Mode for Carrying out the Invention]

(1) First embodiment

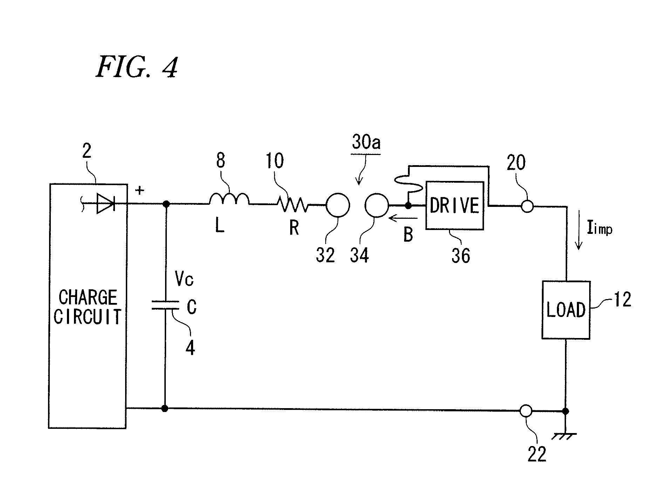

FIG. 4 shows one embodiment of an impulse current generator according to the invention. For simplifying the description, signs R, L, and C of a resistor, an inductance, a capacitance are used common in different circuits, but the values of R, L, and C in the different circuits are not necessarily the same needless to say.

The impulse current generator belongs to the RLC circuit system described above. That is, the impulse current generator is a device for supplying an impulse current $I_{imp}$ to a load 12 and includes a capacitor 4, an inductance 8, a resistor 10, and a discharge gap device 30a connected in series between first and second output terminals 20 and 22 to which the load 12 is connected, and a DC charge circuit 2 for charging the capacitor 4, more specifically, a DC high voltage.

The load 12 is, for example, the above-mentioned surge protection device, any other electric device, etc.

Output voltage of the DC charge circuit 2, namely, charge voltage $V_c$ of the capacity 4 is, for example, about 20 kV, but is not limited to it.

The discharge gap device 30a includes a fixed electrode 32, a movable electrode 34, and an electrode drive 36 for driving the movable electrode 34 toward the fixed electrode 32 as indicated by an arrow B and bringing the movable electrode 34 into contact with the fixed electrode 32.

The electrode drive 36 is, for example, a hydraulic cylinder, an air cylinder, etc.

Before the movable electrode 34 is driven, the discharge start voltage of the discharge gap device 30a is larger than the charge voltage $V_c$ of the capacity 4, of course, and discharge does not occur between the fixed electrode and the movable electrode 34.

In the impulse current generator, if the electrode drive 36 drives the movable electrode 34 toward the fixed electrode 32 in a state in which the capacitor 4 is charged to the predetermined charge voltage $V_c$, when the voltage between the electrodes 32 and 34 is close to the discharge start voltage or less even if a trigger voltage is not applied, discharge occurs between the electrodes 32 and 34 and conduction occurs between the electrodes 32 and 34. Accordingly, the impulse current $I_{imp}$ starts to flow into the load 12 via the inductance 8, the resistor 10, and the discharge gap device 30a by the charge stored in the capacity 4. After this, the movable electrode 34 is driven until it comes in contact with the fixed electrode 32. Accordingly, the impulse current $I_{imp}$ of a predetermined waveform (for example, waveform as shown in FIG. 3) can be supplied to the load 12.

Determination of crest length $T_f$ and duration of wave tail $T_t$ of the impulse current $I_{imp}$ is the same as that previously described with reference to FIG. 1 and will not be discussed again.

If the charge voltage $V_c$ of the capacity 4 is about 20 kV, when the gap between the electrodes 32 and 34 of the discharge gap device 30a becomes, for example, about 10 mm, discharge is started, but the mechanical operation time until both the electrodes 32 and 34 come in contact with each other from the distance usually is far longer than the duration of wave tail $T_t$ of the impulse current $I_{imp}$. However, once discharge starts between the electrodes 32 and 34, plasma occurs between the electrodes 32 and 34 by the discharge. Moreover, the space filled with the plasma continues to be compressed as the movable electrode 34 moves. Thus, if the voltage of the capacitor 4 becomes low in the wave tail part of the impulse current $I_{imp}$, the discharge between the electrodes 32 and 34 can be continued.

To suppress degradation of surfaces of both the electrodes 32 and 34 caused by contact (collision) between the electrodes 32 and 34, the materials of both the electrodes 32 and 34 may be those resistant to the degradation. For example, carbon is one of preferred materials.

As described above, according to the impulse current generator, the movable electrode 34 of the discharge gap device 30a can be driven toward the fixed electrode 32 and can be brought into contact with the fixed electrode 32 by the electrode drive 36, so that if the voltage of the capacitor 4 becomes low in the wave tail part of the impulse current $I_{imp}$, energization in the discharge gap device 30a can be maintained. Therefore, unless the charge voltage $V_c$ of the capacity 4 is made high, a current cut in the wave tail part of the impulse current $I_{imp}$ can be prevented.

For example, if the impulse current $I_{imp}$ of long duration of wave tail of 10/350 $\mu$s described above, a current cut in the wave tail part can be prevented at the charge voltage $V_c$ of about 20 kV. That is, the voltage is reduced to 1/10 of 200 kV described above. Consequently, smaller capacity, miniaturization, and lower cost of the DC charge circuit 2 can be accomplished. Since circuit insulating measures are easy, the const can also be reduced from the viewpoint.

Moreover, the movable electrode 34 of the discharge gap device 30a is driven as described above, whereby discharge in the discharge gap device 30a can be started without providing a trigger electrode, so that a trigger electrode and the trigger circuit become unnecessary. Therefore, the configuration can be simplified and the cost can be reduced.

(2) Second embodiment

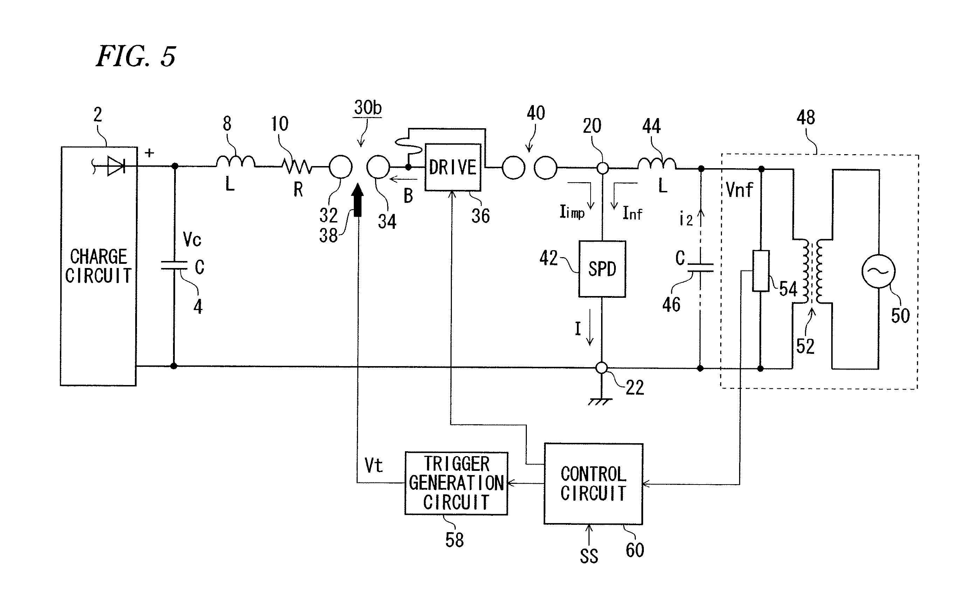

FIG. 5 shows a second embodiment of an impulse current generator according to the invention. Parts identical with or corresponding to those of the first embodiment shown in FIG. 4 are denoted by the same reference numerals and differences from the first embodiment shown in FIG. 4 will be mainly discussed below:

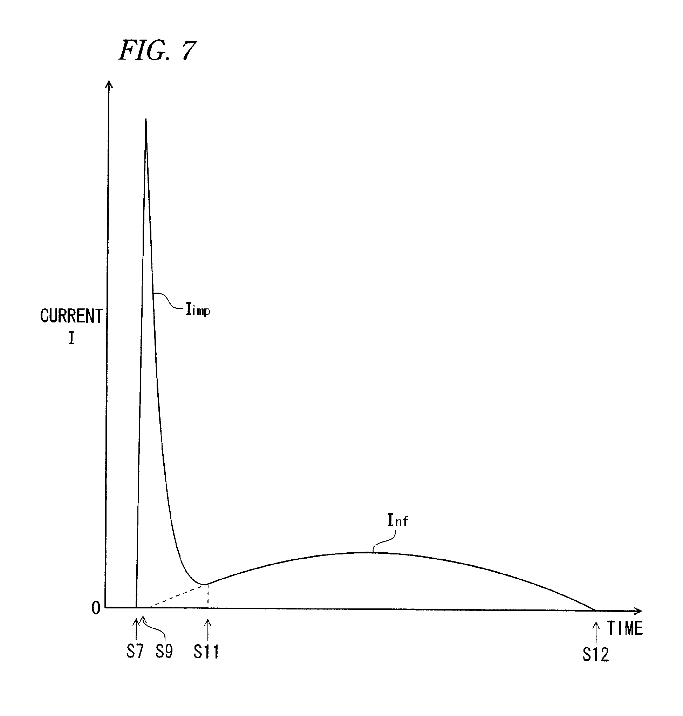

The impulse current generator is a device for supplying a current I provided by superposing a commercial frequency current $I_{nf}$ on an impulse current $I_{imp}$ to a surge protection device 42 to be tested. FIG. 7 shows an example of a waveform of the current I. However, in FIG. 7, the drawing dimensions are limited and thus the amplitude ratio between the impulse current $I_{imp}$ and the commercial frequency current $I_{nf}$ is shown smaller than the actual amplitude ratio.

For example, the peak value of the impulse current $I_{imp}$ is 20 kA. For the waveform, for example, crest length $T_f$/duration of wave tail $T_t$ (see also FIG. 3) is 10/350 $\mu$s. It may be set to 8/20 $\mu$s, etc. For example, the peak value of the commercial frequency current $I_{nf}$ is 500A. It may be set to 5A, etc.

The surge protection device 42 is as described above.

The impulse current generator includes a main capacitor 4, an inductance 8, a resistor 10, a main discharge gap device 30b, and an auxiliary discharge gap 40 connected in series between first and second output terminals 20 and 22 to which the surge protection device 42 is connected, and a DC charge circuit 2 for charging the main capacitor, more specifically, charging a DC high voltage.

The main discharge gap device 30b includes a fixed electrode 32, a movable electrode 34, an electrode drive 36 for driving the movable electrode 34 toward the fixed electrode 32 as indicated by an arrow B and bringing the movable electrode 34 into contact with the fixed electrode 32, and a trigger electrode 38 for starting discharge between the fixed electrode 32 and the movable electrode 34.

The discharge start voltage of the auxiliary discharge gap 40 is lower than a charge voltage $V_c$ of the main capacitor 4 by the DC charge circuit 2 and more specifically is sufficiently low, and is higher than an output voltage of a commercial frequency power supply circuit 48 described below.

For example, the charge voltage $V_c$ of the main capacitor 4 is 20 kV as described above, the output voltage of the commercial frequency power supply circuit 48 is 200 V (effective value), and the discharge start voltage of the auxiliary discharge gap 40 is about 400 V to 500 V. Thus, the discharge start voltage of the auxiliary discharge gap 40 is about 1/40 to 1/50 of the charge voltage $V_c$ and is sufficiently lower than the charge voltage $V_c$.

Therefore, although the overall operation of the device shown in FIG. 5 is described later, if a trigger voltage $V_t$ described later is supplied to the trigger electrode 38 of the main discharge gap device 30b and the main discharge gap device 30b is discharged (namely, is brought into conduction), the auxiliary discharge gap 40 is also discharged (namely, is brought into conduction), whereby the impulse current $I_{imp}$ can be supplied to the surge protection device 42.

The impulse current generator further includes the commercial frequency power supply circuit 48 connected in series through a reactor 44 between the first and second output terminals 20 and 22 for outputting a current $I_{nf}$ of a commercial frequency $f_n$ (namely, commercial frequency current) and a trigger generation circuit 58 for supplying the trigger voltage $V_t$ to the trigger electrode 38 of the main discharge gap device 30b.

The commercial frequency power supply circuit 48 includes, for example, a commercial frequency power supply 50, a transformer 52, and a voltage divider 54 for dividing an output voltage of the commercial frequency power supply circuit 48 and outputting. The commercial frequency power supply 50 is a commercial power supply of 60 Hz, 200 V, for example. The transformer 52 is an insulating transformer whose primary voltage/secondary voltage is 200 V/200 V. The transformer is mainly intended for insulating and thus is not indispensable for the invention.

The impulse current generator further includes a control circuit 60 for performing control for synchronizing drive of the movable electrode 34 by the electrode drive 36 of the main discharge gap device 30b and output of the trigger voltage $V_t$ from the trigger generation circuit 58 with each other and moreover performing control for outputting the trigger voltage $V_t$ when the output voltage of the commercial frequency power supply circuit 48 is a predetermined phase. In the example, the control circuit 60 measures the phase of the output voltage of the commercial frequency power supply circuit 48 using the voltage from the voltage divider 54 and performs the above-described control.

Preferably, the control circuit 60 performs control for outputting the trigger voltage $V_t$ from the trigger generation circuit 58 when the phase of the output voltage of the commercial frequency power supply circuit 48 is almost $\pi/2$ [rad]; in the embodiment, the control circuit 60 performs such control. The reason is as follows:

When the impulse current $I_{imp}$ is supplied to the surge protection device 42, the surge protection device 42 operates and demonstrates the essential function (namely, function of limiting the surge voltage and diverting the surge current). At this time, in brief, the surge protection device 42 abruptly conducts with a very small resistance value.

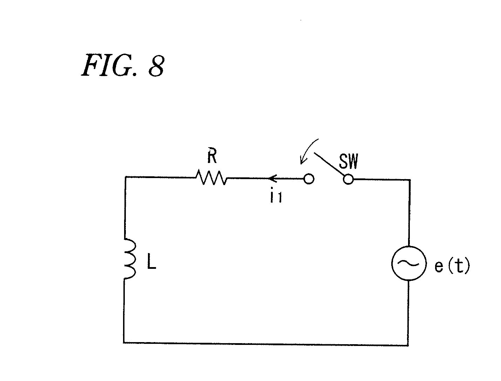

If abrupt conduction of the surge protection device 42 is regarded as turning on operation of a switch, the series circuit of the commercial frequency power supply circuit 48, the reactor 44, and the surge protection device 42 becomes substantially equivalent to a circuit shown in FIG. 8. That is, an AC power supply e(t) corresponds to the commercial frequency power supply circuit 48, a switch SW corresponds to the surge protection device 42, an inductance L corresponds to the reactor 44, and a resistor R corresponds to a resistor of a circuit other than the surge protection device 42.

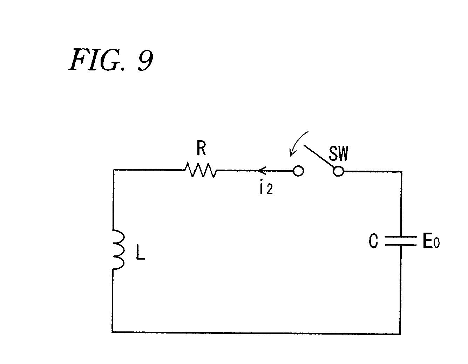

FIG. 8 is an example often described in books describing a transient phenomenon. Similar comments apply to FIG. 9.

In the circuit in FIG. 8, if a current flowing when the switch SW is turned on with t=0 and AC voltage e (t) = $E_m$sin $(\omega t+\theta)$ is applied is $i_1$, a circuit equation becomes the following expression. $E_m$ is the maximum value of AC voltage, $\omega$ is an angular frequency, and $\theta$ is a phase of AC voltage when the switch SW is turned on.

[Expression 1]

$$L \ (di_1/dt) \ + \ Ri_1 \ = \ E_m sin \ (\omega t+\theta)$$

From the expression, when t = 0, if initial condition of $i_1$ is applied and current $i_1$ is found, expression 2 applies. Here, Z is impedance of the RL series circuit and $\theta$ is a delay phase and they are expressed by expression 3.

[Expression 2]

$$i_1 = \frac{E_m}{|Z|}\left[\sin(\omega t + \theta - \phi) - \varepsilon^{-\frac{R}{L}t}\sin(\theta - \varphi)\right]$$

[Expression 3]

$$|Z| \ = \ \sqrt{} \ (R^2 \ + \ \omega^2 L^2),$$

$$\phi = \tan^{-1}(\omega L/R)$$

The first term of the right side of Expression 2 represents a stationary current and the second term represents a transient current. Therefore, if sin $(\theta - \phi) = 0$, namely, $\theta = \phi$, a transient phenomenon does occur and a stationary current of a sine wave expressed by the following expression as current $i_1$ flows:

$$[Expression\ 4]$$

$$i_1 = (E_m/|Z|)\ \sin\omega t$$

If this applies to the device shown in FIG. 5, preferably when $\theta = \phi$, namely, the phase $\theta$ of the output voltage of the commercial frequency power supply circuit 48 is almost equal to the delay phase $\phi$ of the series circuit containing the reactor 44 and the surge protection device 42, the main discharge gap device 30b and the auxiliary discharge gap 40 are discharged and the surge protection device 42 is brought into conduction by the impulse current $I_{imp}$. More specifically, the delay phase $\phi$ becomes almost $\pi/2$ [rad] because the resistance R of the series circuit is very small as compared with the inductance L of the reactor 44 in the device in FIG. 5. Therefore, preferably, when the phase $\theta$ of the output voltage of the commercial frequency power supply circuit 48 is almost $\pi/2$ [rad] , the trigger voltage $V_t$ is output from the trigger generation circuit 58 and the main discharge gap device 30b and the auxiliary discharge gap 40 are discharged.

If the current $i_1$ at the time is applied to the device shown in FIG. 5, $\omega = 2\pi f_n$ is assigned to Expression 4 and the current $i_1$ is expressed by the following expression. The current $i_1$ flows as the commercial frequency current $I_{nf}$. Em is the peak value of the output voltage of the commercial frequency power supply circuit 48 (for example, $\sqrt{2} \times 200$ V).

$$[Expression\ 5]$$

$$i_1 = (Em/|Z|)\ \sin 2\pi f_n t$$

By so doing, the commercial frequency current $I_{nf}$ supplied from the commercial frequency power supply circuit 48 to the surge protection device 42 can be raised from almost 0 at the conducting time of the surge protection device 42 and a transient current can be prevented from occurring in the commercial frequency current $I_{nf}$. Consequently, as in the example shown in FIG. 7, current I of a waveform with the commercial frequency current $I_{nf}$ well joined to the impulse current $I_{imp}$ can be supplied to the surge protection device 42, so that it is made possible to more precisely conduct a commercial frequency current superposition test for the surge protection device 42.

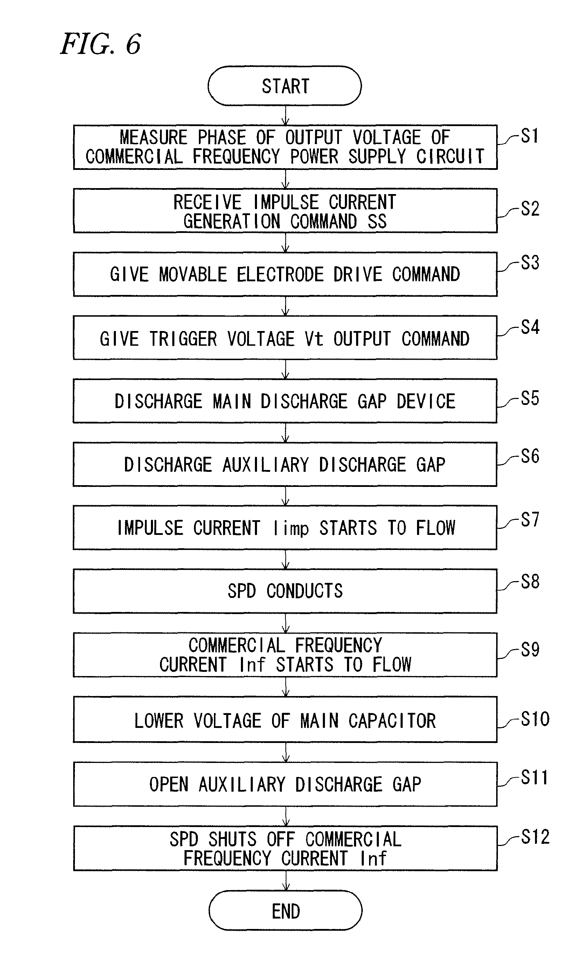

Next, an example of the operation of the impulse current generator shown in FIG. 5 will be discussed with a control portion of the control circuit 60 as the main with reference to FIG. 6.

The main capacitor is charged to the predetermined charge voltage $V_c$ by the DC charge circuit 2. The commercial frequency power supply circuit 48 is operated and then voltage of the commercial frequency $f_n$.

The control circuit 60 continuously measures the phase $\theta$ of the output voltage of the commercial frequency power supply circuit 48 (step S1) before receiving an impulse current generation command SS described later. Therefore, the control circuit 60 can determine the point in time at which the phase $\theta$ of the output voltage of the commercial frequency power supply circuit 48 becomes $\pi/2$ (hereinafter, the unit rad will be omitted). The point in time at which the phase $\theta$ becomes $\pi/2$ comes in a given period (namely, the period of the commercial frequency $f_n$).

When a test of supplying the current I with the commercial frequency current $I_{nf}$ superposed on the impulse current $I_{imp}$ to the surge protection device 42 to be tested is executed, the impulse current generation command SS is given to the control circuit 60 (step S2). The impulse current generation command SS may be a contact signal by a switch or may be a command signal from another control circuit, for example.

Letting the time difference between the time of giving a drive command to the electrode drive 36 of the main discharge gap device 30b and the time of outputting the trigger voltage $V_t$ from the trigger generation circuit 58 be Td, upon reception of the impulse current generation command SS, the control circuit 60 gives the drive command to the electrode drive 36 of the main discharge gap device 30b the time difference Td before the phase of the output voltage of the commercial frequency power supply circuit 48 becomes $\pi/2$ (step S3). Responding to it, the electrode drive 36 starts to drive the movable electrode 34 and continues to drive the movable electrode 34 until the movable electrode 34 comes in contact with the fixed electrode 32. The point in time at which the phase of the output voltage of the commercial frequency power supply circuit 48 becomes $\pi/2$ as mentioned above comes repeatedly in a given period, so that the control circuit 60 can perform the above-described control.

Just after it, namely, in the time difference Td, the control circuit 60 gives an output command to the trigger generation circuit 58 for outputting the trigger voltage $V_t$ (step S4). Responding to the command, the trigger generation circuit 58 outputs the trigger voltage $V_t$ and supplies it to the trigger electrode 38. Accordingly, when the phase of the output voltage of the commercial frequency power supply circuit 48 becomes $\pi/2$, the trigger voltage $V_t$ can be output. The moving electrode 34 is driven and the trigger voltage $V_t$ is supplied, whereby discharge occurs between the fixed electrode 32 and the movable electrode 34 and conduction occurs between the electrodes 32 and 34. That is, the main discharge gap device 30b discharges and conducts (step S5).

When discharge in the main discharge gap device 30b can be started by applying the trigger voltage $V_t$ if the movable electrode is not so much moved, the time difference Td may be a very small value. It may be almost 0 in some cases. In such a case, drive start of the movable electrode 34 and applying of the trigger voltage $V_t$ are almost at the same time.

The length of the time difference $T_d$ and the output timing of the trigger voltage $V_t$ may be able to be adjusted. In so doing, control for outputting the trigger voltage $V_t$ when the phase of the output voltage of the commercial frequency power supply circuit 48 becomes $\pi/2$, etc., can be performed more flexibly.

As the main discharge gap device 30b conducts, the charge voltage $V_c$ of the main capacitor 4 is applied to the auxiliary discharge gap 40 and thus the auxiliary discharge gap 40 discharges and conducts (step S6). Accordingly, the impulse current $I_{imp}$ starts to flow into the surge protection device 42 via the inductance 8, the resistor 10, the main discharge gap device 30b, and the auxiliary discharge gap 40 by the charge stored in the main capacitor 4 (step S7. Also see FIG. 7). An example of the peak value and the waveform of the impulse current $I_{imp}$ is as described above.

At this time, the reactor 44 acts like an inhibition filter for the impulse current $I_{imp}$ and thus can inhibit flow of the impulse current $I_{imp}$ to the commercial frequency power supply circuit 48. In this case, the inductance L of the reactor 44 is about 800 $\mu$H by way of example, but is not limited to it and may be any if the reactor inhibits the flow. If the inductance L is large as a resonance condition is satisfied described later in cooperation with an auxiliary capacitor 46 described later, the reactor 44 performs the inhibition action described above.

When the impulse current $I_{imp}$ flows into the surge protection device 42, the surge protection device 42 conducts in a very small resistance value as described above and thus the commercial frequency current $I_{nf}$ starts to flow into the surge protection device 42 from the commercial frequency power supply circuit 48 (step S9. Also see FIG. 7). The commercial frequency current $I_{nf}$ is superposed on the impulse current $I_{imp}$ and flows until discharge of the auxiliary discharge gap 40 stops, the auxiliary discharge gap 40 is opened, and the impulse current $I_{imp}$ terminates. An example of the peak value of the commercial frequency current $I_{nf}$ is as described above.

The impulse current $I_{imp}$ is supplied, whereby the voltage of the main capacitor lowers (step S10). However, the movable electrode 34 is brought into contact with the fixed electrode 32 by the electrode drive 36 of the main discharge gap device 30b as described above. Thus, if the voltage of the main capacitor 4 lowers in the wave tail part of the impulse current $I_{imp}$, conduction in the main discharge gap device 30b can be maintained as with the case of the first embodiment. Moreover, the discharge start voltage of the auxiliary discharge gap 40 is sufficiently lower than the charge voltage $V_c$ of the main capacitor 4 as described above. Thus, if the voltage of the main capacitor 4 lowers in the wave tail part of the impulse current $I_{imp}$, conduction in the auxiliary discharge gap 40 can be maintained for a long term. Therefore, if the charge voltage $V_c$ of the main capacitor 4 is not made high, current cut in the wave tail part of the impulse current $I_{imp}$ can be prevented.

Voltage lowering of the main capacitor 4 further advances, discharge in the auxiliary discharge gap 40 naturally disappears and the auxiliary discharge gap 40 is opened (step S11. Also see FIG. 7). Accordingly, if both electrodes 32 and 34 of the main discharge gap device 30b continue to conduct by contact, the commercial frequency power supply circuit 48 and the impulse source side (namely, to the main capacitor side 4 from the auxiliary discharge gap 40 and so forth on) can be separated. Accordingly, flow of the commercial frequency current into the impulse source side can be inhibited and the current supplied to the surge protection device 42 can be well continuously switched from the impulse current $I_{imp}$ to the commercial frequency current $I_{nf}$ and as a continuous flow of the impulse current $I_{imp}$, the commercial frequency current $I_{nf}$ can be well supplied to the surge protection device 42 (see FIG. 7).

Then, the commercial frequency current $I_{nf}$ flows into the surge protection device 42. If the function of the surge protection device 42 is normal, the commercial frequency current $I_{nf}$ is shut off in a half cycle by the surge protection device 42 (step S12. Also see FIG. 7). Testing as to whether or not the shut off is normally performed is the main purpose of the commercial frequency current superposition test mentioned above.

By the way, an auxiliary capacitor 46 connected in parallel to the commercial frequency power supply circuit 48 between the commercial frequency power supply circuit 48 and the reactor 44 for forming a resonance circuit for resonating at the commercial frequency $f_n$ in cooperation with the reactor 44 (more specifically, series resonance circuit) as indicated by an alternate long and two short dashes line in FIG. 5 may be included.

Also in this case, if abrupt conduction of the surge protection device 42 is regarded as turning on operation of a switch, the series circuit of the auxiliary capacitor 46, the reactor 44, and the surge protection device 42 shown in FIG. 5 becomes equivalent to a circuit shown in FIG. 9. That is, a capacitor C corresponds to the auxiliary capacitor 46, a switch SW corresponds to the surge protection device 42, an inductance L corresponds to the reactor 44, and a resistor R corresponds to a resistor of a circuit other than the surge protection device 42. The capacitor C, namely, the auxiliary capacitor 46 is charged by the commercial frequency power supply circuit 48.

In the circuit in FIG. 9, assuming that the capacitor C is charged to a voltage $E_0$, if the switch SW is turned on with t=0, a transient current $i_2$ flows by the charge stored in the capacitor C. Considering the device shown in FIG. 5, the resistance R is very small as compared with the inductance L as described above and the following Expression 6 holds and thus the current $i_2$ becomes a damped oscillation current like a sine wave expressed in Expression 7. The second line of Expression 7 is the result of applying a condition of Expression 6 to the first line.

$$[\text{Expression 6}]$$

$$(1/LC) \gg (R/2L)^2$$

$$i_2 = \frac{E_0}{L\sqrt{\dfrac{1}{LC} - \left(\dfrac{R}{2L}\right)^2}} \varepsilon^{-\frac{R}{2L}t} \sin\sqrt{\frac{1}{LC} - \left(\frac{R}{2L}\right)^2} \, t$$

$$\approx \frac{E_0}{\sqrt{\dfrac{L}{C}}} \varepsilon^{-\frac{R}{2L}t} \sin\frac{1}{LC} t$$

If the description given above applies to the device shown in FIG. 5, when the surge protection device 42 abruptly conducts, the transient current $i_2$ shown in the second line of Expression 7 flows into the surge protection device 42 from the auxiliary capacitor 46. As described above, when the phase of the output voltage of the commercial frequency power supply circuit 48 is $\pi/2$, the main discharge gap device 30b, etc., discharges and the surge protection device 42 is brought into conduction. Thus, the voltage $E_0$ in Expression 7 becomes almost equal to the peak value of the output voltage of the commercial frequency power supply circuit 48 (for example, $\sqrt{2} \times 200$ V).

Moreover, in the device shown in FIG. 5, as described above, the reactor 44 and the auxiliary capacitor 46 satisfy the resonance condition at the commercial frequency $f_n$ and thus the following expression holds:

$$[\text{Expression 8}]$$

$$f_n = 1/2 \, \pi\sqrt{(LC)}$$

In this case, for example, the commercial frequency $f_n$ is 60 Hz, the inductance L of the reactor 44 is 78 mH, and the capacitance C of the auxiliary capacitor 46 is 90 $\mu$F.

If Expression 8 is assigned to the second line of Expression 7, after all, the transient current $i_2$ flowing from the auxiliary capacitor 46 becomes the following expression and the current $i_2$ like a sine wave oscillating (damped oscillating) at the commercial frequency $f_n$ can be supplied from the auxiliary capacitor 46 to the surge protection device 42.

[Expression 9]

$$i_2 \approx \frac{E_0}{\sqrt{\dfrac{L}{C}}} \varepsilon^{-\frac{R}{2L}t} \sin 2\pi f_n t$$

Therefore, in this example, as the commercial frequency current $I_{nf}$, the current $i_1$ shown in Expression 5 of the same commercial frequency $f_n$ (the current is supplied from the commercial frequency power supply circuit 48) and the current $i_2$ shown in Expression 9 (the current is supplied from the auxiliary capacitor 46) are synchronized with each other and are superposed on each other and flow into the surge protection device 42. That is, $I_{nf} = i_1 + i_2$ flows. The fact that both currents $i_1 + i_2$ are synchronized with each other is also seen from the fact that the phases of sin in Expressions 5 and 9 match.

Thus, in the example, current of the commercial frequency $f_n$ can be supplied to the surge protection device 42 from other than the commercial frequency power supply circuit 48. Thus, to supply the commercial frequency current $I_{nf}$ of a predetermined size to the surge protection device 42, the capacity of the commercial frequency power supply circuit 48 can be lessened. Accordingly, miniaturization, cost reduction, etc., of the commercial frequency power supply circuit 48 and in turn, miniaturization, cost reduction, etc., of the impulse current generator can be accomplished.

**Claims**

1.  An impulse current generator for supplying an impulse current to a load, comprising:

    first and second output terminals to which the load is connected;
    a capacitor, an inductance, a resistor, and a discharge gap device connected in series between the first and second output terminals; and
    a DC charge circuit configured to charge the capacitor,
    wherein the discharge gap device comprises a fixed electrode, a movable electrode, and an electrode drive configured to drive the movable electrode toward the fixed electrode and to bring the movable electrode into contact with the fixed electrode.

2.  An impulse current generator for supplying a current with a commercial frequency current superposed on an impulse current to a surge protection device to be tested, said impulse current generator comprising:

    first and second output terminals to which the surge protection device is connected;
    a main capacitor, an inductance, a resistor, a main discharge gap device, and an auxiliary discharge gap connected in series between the first and second output terminals, the main discharge gap device comprising a fixed electrode, a movable electrode, an electrode drive configured to drive the movable electrode toward the fixed electrode and to bring the movable electrode into contact with the fixed electrode, and a trigger electrode configured to start discharge between the fixed electrode and the movable electrode;
    a DC charge circuit configured to charge the main capacitor;
    a commercial frequency power supply circuit connected in series through a reactor between the first and second output terminals and configured to output a current of a commercial frequency;
    a trigger generation circuit configured to supply a trigger voltage to the trigger electrode of the main discharge gap device; and
    a control circuit configured to perform control for synchronizing drive of the movable electrode by the electrode drive device of the main discharge gap device and output of the trigger voltage from the trigger generation circuit with each other, and to perform control for outputting the trigger voltage when the output voltage of the commercial frequency power supply circuit is a predetermined phase,

wherein discharge start voltage of the auxiliary discharge gap is lower than the discharge voltage of the main capacitor and is higher than output voltage of the commercial frequency power supply circuit.

3. The impulse current generator as claimed in claim 2 wherein the control circuit performs control for outputting the trigger voltage from the trigger generation circuit when the phase of the output voltage of the commercial frequency power supply circuit is almost $\pi/2$ [rad].

4. The impulse current generator as claimed in claim 2 or 3 comprising:

an auxiliary capacitor connected in parallel to the commercial frequency power supply circuit between the commercial frequency power supply circuit and the reactor and configured to form a resonance circuit resonating at the commercial frequency in cooperation with the reactor.

FIG. 1

*FIG. 2*

## FIG. 3

## FIG. 4

*FIG. 5*

## FIG. 6

```
                    START
                      │
                      ▼
┌─────────────────────────────────────────┐
│ MEASURE PHASE OF OUTPUT VOLTAGE OF       │──S1
│ COMMERCIAL FREQUENCY POWER SUPPLY CIRCUIT│
└─────────────────────────────────────────┘
                      │
                      ▼
┌─────────────────────────────────────────┐
│ RECEIVE IMPULSE CURRENT                  │──S2
│ GENERATION COMMAND SS                    │
└─────────────────────────────────────────┘
                      │
                      ▼
┌─────────────────────────────────────────┐
│ GIVE MOVABLE ELECTRODE DRIVE COMMAND     │──S3
└─────────────────────────────────────────┘
                      │
                      ▼
┌─────────────────────────────────────────┐
│ GIVE TRIGGER VOLTAGE Vt OUTPUT COMMAND   │──S4
└─────────────────────────────────────────┘
                      │
                      ▼
┌─────────────────────────────────────────┐
│ DISCHARGE MAIN DISCHARGE GAP DEVICE      │──S5
└─────────────────────────────────────────┘
                      │
                      ▼
┌─────────────────────────────────────────┐
│ DISCHARGE AUXILIARY DISCHARGE GAP        │──S6
└─────────────────────────────────────────┘
                      │
                      ▼
┌─────────────────────────────────────────┐
│ IMPULSE CURRENT Iimp STARTS TO FLOW      │──S7
└─────────────────────────────────────────┘
                      │
                      ▼
┌─────────────────────────────────────────┐
│ SPD CONDUCTS                             │──S8
└─────────────────────────────────────────┘
                      │
                      ▼
┌─────────────────────────────────────────┐
│ COMMERCIAL FREQUENCY                     │──S9
│ CURRENT Inf STARTS TO FLOW               │
└─────────────────────────────────────────┘
                      │
                      ▼
┌─────────────────────────────────────────┐
│ LOWER VOLTAGE OF MAIN CAPACITOR          │──S10
└─────────────────────────────────────────┘
                      │
                      ▼
┌─────────────────────────────────────────┐
│ OPEN AUXILIARY DISCHARGE GAP             │──S11
└─────────────────────────────────────────┘
                      │
                      ▼
┌─────────────────────────────────────────┐
│ SPD SHUTS OFF COMMERCIAL                 │──S12
│ FREQUENCY CURRENT Inf                    │
└─────────────────────────────────────────┘
                      │
                      ▼
                    END
```

*FIG. 7*

## FIG. 8

## FIG. 9

Europäisches
Patentamt
European
Patent Office
Office européen
des brevets

# EUROPEAN SEARCH REPORT

Application Number

EP 10 19 5160

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 90/11052 A1 (WIKSELL HANS [SE]) 4 October 1990 (1990-10-04) | 1 | INV. G01R31/00 |
| A | * page 2, line 10 - line 20 * * page 4, line 5 - line 22; claim 1; figures 2-4 * | 2-4 | |
| A | JP 2002 340958 A (JAPAN TECH RES & DEV INST; FUJI ELECTRIC RES) 27 November 2002 (2002-11-27) * abstract; figures 1,2 * | 1-4 | |
| A | CN 201 222 073 Y (UNIV WUHAN [CN]) 15 April 2009 (2009-04-15) * figures 3,5,6 * | 1-4 | |
| X | US 5 506 454 A (HANZAWA KEIJI [JP] ET AL) 9 April 1996 (1996-04-09) * figure 1a * | 1 | |
| X | US 2 990 514 A (JOHNSON GRAHAM H) 27 June 1961 (1961-06-27) * figure 7 * | 1 | TECHNICAL FIELDS SEARCHED (IPC) G01R H05H |

The present search report has been drawn up for all claims

| Place of search | Date of completion of the search | Examiner |
|---|---|---|
| Berlin | 21 April 2011 | Binger, Bernard |

## ANNEX TO THE EUROPEAN SEARCH REPORT
## ON EUROPEAN PATENT APPLICATION NO.

EP 10 19 5160

This annex lists the patent family members relating to the patent documents cited in the above-mentioned European search report.
The members are as contained in the European Patent Office EDP file on
The European Patent Office is in no way liable for these particulars which are merely given for the purpose of information.

21-04-2011

| Patent document cited in search report | | Publication date | Patent family member(s) | | Publication date |
|---|---|---|---|---|---|
| WO 9011052 | A1 | 04-10-1990 | EP<br>JP<br>SE<br>SE<br>US | 0473601 A1<br>4504215 T<br>465600 B<br>8900995 A<br>5231976 A | 11-03-1992<br>30-07-1992<br>07-10-1991<br>22-09-1990<br>03-08-1993 |
| JP 2002340958 | A | 27-11-2002 | JP | 4117700 B2 | 16-07-2008 |
| CN 201222073 | Y | 15-04-2009 | NONE | | |
| US 5506454 | A | 09-04-1996 | NONE | | |
| US 2990514 | A | 27-06-1961 | NONE | | |

EPO FORM P0459

For more details about this annex : see Official Journal of the European Patent Office, No. 12/82